## Europäisches Patentamt
## European Patent Office
## Office européen des brevets

(19)

(11) Publication number: **0 117 253**
**A1**

(12)

# EUROPEAN PATENT APPLICATION

published in accordance with Art. 158(3) EPC

(21) Application number: **83902697.8**

(51) Int. Cl.³: **H 03 H 9/10**

(22) Date of filing: **25.08.83**

Data of the international application taken as a basis:

(86) International application number:
**PCT/JP 83/00278**

(87) International publication number:
**WO 84/01064 (15.03.84 84/7)**

(30) Priority: **25.08.82 JP 147227/82**

(43) Date of publication of application: **05.09.84**
**Bulletin 84/36**

(84) Designated Contracting States: **DE FR**

(71) Applicant: **FUJI SANGYO KABUSHIKI KAISHA,**
**1-11 Fujimigaoka 2-chome, Nirasaki-shi**
**Yamanashi 407 (JP)**

(72) Inventor: **IWASHITA, Isao Fuji Sangyo Kabushiki Kaisha,**
**1-11, Fujimigaoka 2-chome, Nirasaki-shi**
**Yamanashi 407 (JP)**
Inventor: **TSUCHIYA, Yasuhisa Fuji Sangyo Kabushiki**
**Kaisha, 1-11, Fujimigaoka 2-chome, Nirasaki-shi**
**Yamanashi 407 (JP)**
Inventor: **SAIGUSA, Yasutaka Fuji Sangyo Kabushiki**
**Kaisha, 1-11, Fujimigaoka 2-chome, Nirasaki-shi**
**Yamanashi 407 (JP)**

(74) Representative: **Tetzner, Volkmar, Dr.-Ing. Dr. Jur.,**
**Van-Gogh-Strasse 3, D-8000 München 71 (DE)**

(54) **CYLINDRICAL PIEZOELECTRIC VIBRATOR.**

(57)    A piezoelectric vibrating plate ($6_1$) is held in a cylindrical container (7) which has an insulating property, and both ends of the container (7) are sealed with metal caps (8) which are used as electrodes. The electric connection between the plate ($6_1$) and the caps (8) can be by a conductive adhesive ($5_2$) or by elastic conductive pieces (9).

DESCRIPTION

TITLE OF THE INVENTION

CYLINDRICAL PIEZO-ELECTRIC RESONATOR

TECHNICAL FIELD

The present invention relates to a piezo-electric resonator having a piezo-electric vibrating plate incorporated into a sealed container.

BACKGROUND ART

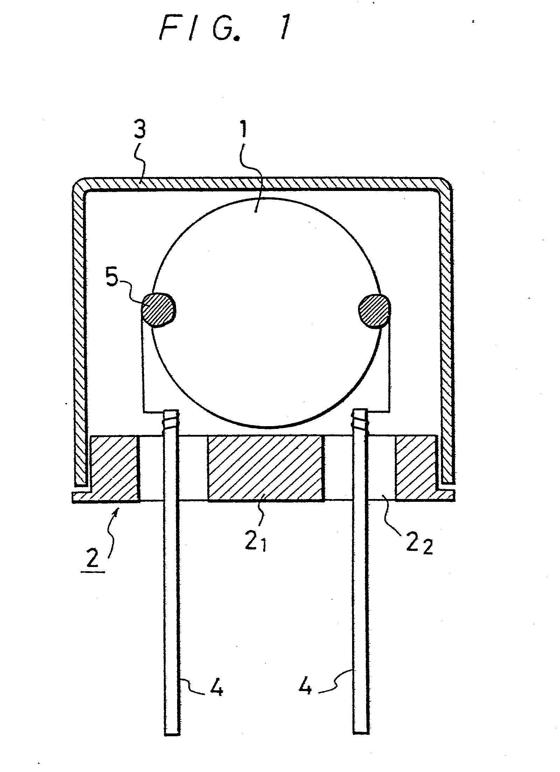

Almost all of conventional piezo-electric resonator are constructed as shown in Fig. 1. In Fig. 1, reference numeral 1 designates a piezo-electric vibrating plate, 2 a hermetic base, $2_1$ a metal portion thereof, $2_2$ glass portions thereof, 3 a cap, 4 lead lines and 5 conductive bonding agents. The materials of the metal portion $2_1$ of the hermetic base and the cap 3 are iron, new silver, copper, Kovar and the like. The lead lines 4 are led out through the glass portions $2_2$ of the hermetic base from the inside of the container to its outside. The lead lines are electrically connected to electrodes of the piezo-electric vibrating plate 1 within the container. The hermetic base 2 and the cap 3 are connected to each other by soldering or cold press. Such prior art piezo-electric resonator requires much material cost and time so that the price thereof becomes high. Also the conventional piezo-electric resonator requires much manual labor and is poor in mass-productivity and can not be mounted automatically.

The present invention is to provide a piezo-electric resonator which can obviate all the defects inherent in the prior art piezo-electric resonator.

## DISCLOSURE OF INVENTION

According to the present invention, a piezo-electric vibrating plate is incorporated into a cylindrical container having an insulative property and both ends of this container are sealed by metal caps to thereby use the metal caps as electrodes of the piezo-electric vibrating plate. The electrical connection between the piezo-electric vibrating plate and the metal caps is carried out by conductive bonding agents or resilient conductive pieces.

## BRIEF DESCRIPTION OF THE DRAWINGS

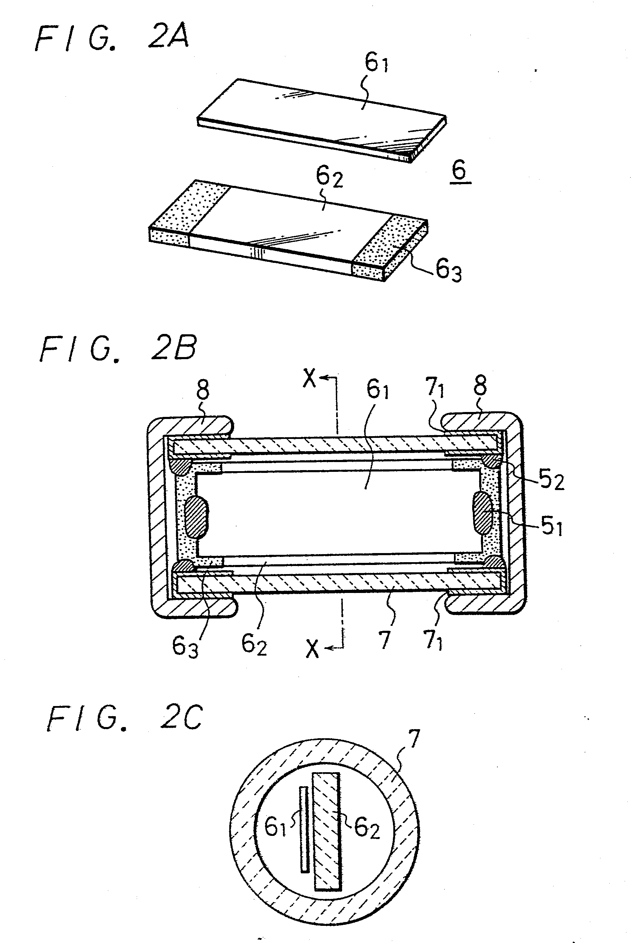

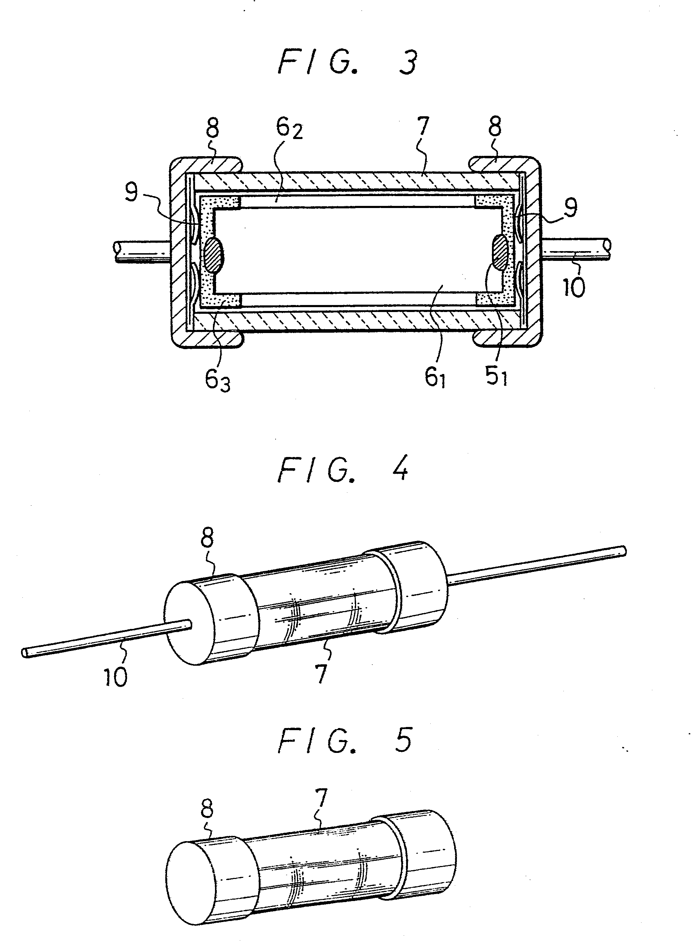

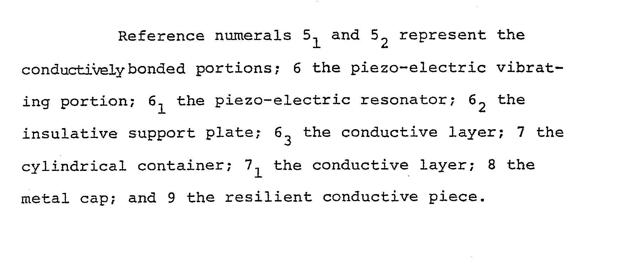

Fig. 1 is a partially cross-sectional diagram showing a prior art example; Fig. 2 is a diagram showing a first embodiment of the present invention in which Fig. 2A is an exploded perspective diagram of a piezo-electric vibrating portion thereof, Fig. 2B is a partially cross-sectional diagram of its piezo-electric resonator and Fig. 2C is a cross-sectional diagram taken along a line X - X in Fig. 2B; Fig. 3 is a partially cross-sectional diagram showing a second embodiment of the present invention; Fig. 4 is a diagram showing the present invention with a lead line; and Fig. 5 is a diagram showing the appearance of the present invention without the lead line.

## BEST MODE FOR CARRYING OUT THE INVENTION

Fig. 2 is a diagram showing an embodiment of the present invention in which Fig. 2A is an exploded perspective diagram of a piezo-electric vibrating portion thereof, Fig. 2B is a partially cross-sectional diagram of a piezo-electric resonator thereof and Fig. 2C is a cross-sectional diagram taken along a line X - X in Fig. 2B. In Fig. 2A, reference numeral 6 generally designates a piezo-electric vibrating portion, $6_1$ designates a piezo-electric vibrating plate and $6_2$ an insulative support plate which supports the piezo-electric vibrating plate $6_1$. The piezo-electric vibrating plate $6_1$ is so formed to have a shape which is easily incorporated into a cylindrical container (the rectangular shape in the illustrative example). The insulative support plate $6_2$ has the similar shape to the former but the length and width thereof are selected somewhat larger than those of the piezo-electric vibrating plate $6_1$. The insulative support plate $6_2$ is made of ceramics material, glass or the like and the both ends of which are metalized. Reference numeral $6_3$ designate the metalized portions. The piezo-electric vibrating plate $6_1$ is located on the insulative support plate $6_2$ and the piezo-electric vibrating plate $6_1$ is fixed at its both ends to the above metalized portions $6_3$ by conductive bonding agents $5_1$ (see Fig. 2B). Even if the piezo-electric vibrating plate $6_1$ is bonded through the metalized layers $6_3$ to the insulative support plate $6_2$, there is provided a small spacing between the piezo-electric vibrating plate $6_1$ and the support plate $6_2$ so that no influence is exerted on the vibration of the piezo-electric vibrating plate $6_1$. Such combined member is called a piezo-electric vibrating portion for convenience.

In Fig. 2B, like parts corresponding to those in Fig. 2A are marked with the same references.

Reference numeral 7 designates a cylindrical container (the trunk form in the illustrative example) which is formed of an insulative material such as ceramics, plastic resin, glass or the like. Such cylindrical container of insulating property is low in material cost and can be produced at low prices. The both ends of the cylindrical container 7 is metalized continuously from the inner peripheral surface to the external peripheral surface thereof. Reference numeral $7_1$ designates such a metalized portion. Then, the above piezo-electric vibrating portion 6 is inserted into the cylindrical container 7 and bonded thereto by the conductive bonding agent $5_2$. To this end, it is desired that the inner diameter and the length of the cylindrical container 7 are selected to be approximately the same as the width and length of the piezo-electric vibrating portion 6. Then, metal caps 8 are pressedly fitted to the both ends of the cylindrical container 7 and heated, if necessary. Thus, the inner peripheral surfaces of the metal cap 8 and the metalized portions $7_1$ of the cylindrical container 7 are closely connected to each other to enable the inside of the cylindrical container to be kept in air tight. If necessary, coating material is applied thereto. Each of the metal caps 8 is electrically connected through the metalized portion $7_1$, the conductive bonding agent $5_2$, the metalized portion $6_3$ and the conductive bonding agent $5_1$ to the piezo-electric vibrating plate $6_1$ to serve as the electrode. If necessary, the lead lines are connected to the metal caps. When the metal caps 8 are soldered to tip electrodes and then used as tip parts, it is not necessary to connect the lead lines.

Fig. 3 is a partially cross-sectional diagram showing another embodiment of the present invention. In the figure, like parts corresponding to those in Fig. 2 are marked with the same references. In this embodiment, the piezo-electric vibrating portion 6 is formed in the same way as the preceding embodiment but the method to electrically connect the metal caps 8 to the metalized portion $6_3$ of the piezo-electric vibrating portion 6 is different from the former. Reference numeral 9 designates a resilient conductive piece which is formed by approprietely bending a metal piece. When this resilient conductive piece is inserted into the metal cap 8 which then is pressedly fitted into each of both ends of the cylindrical container 7, the metal cap 8 is electrically connected through the resilient conductive piece 9, the metalized portion $6_3$ and the conductive bonding agent $5_1$ to the piezo-electric vibrating plate $6_1$. As is shown in the figure, a lead line 10 is connected to the metal cap 8 and various ways of connecting the lead line 10 to the metal cap can be considered. For example, the connection can be carried out by soldering. Moreover, it is also possible to connect the lead line 10 to the metal cap 8 in advance.

Fig. 4 is a diagram showing the appearence of the piezo-electric resonator with the lead line connected thereto according to the present invention, while Fig. 5 is a diagram showing the appearance of the piezo-electric resonator with no lead line connected thereto according to the present invention.

While in the above embodiments the cylindrical container is formed of the insulative material, it is sufficient that the above material has insulating property at least on its surface. For example, a material, for example, metal aluminium with an insulative coating formed on its surface by alumite-treating can be used for making the cylindrical container of the present invention. In addition, while the piezo-electric vibrating plate $6_1$ is formed to be rectangular in shape, the piezo-electric vibrating plate can be formed to be square or circular shape in some case. In that case, it is possible that the metal cap 8 and the piezo-electric vibrating plate $6_1$ are electrically connected to each other in the same way.

INDUSTRIAL APPLICABILITY

As set forth above, the cylindrical piezo-electric resonator according to the present invention has the following remarkable usefulness.

(a) Material cost is low and the manufacturing cost can be lowered.

(b) The cylindrical piezo-electric resonator of the invention is manufactured easily and it is suitable for the mass-production.

(c) When the cylindrical piezo-electric resonator according to the present invention is mounted on a base or the like, the cylindrical piezo-electric resonator with the lead line connected thereto can automatically be mounted, while the cylindrical piezo-electric resonator with no lead line connected thereto can promote the automatic mounting thereof as tip parts.

CLAIMS

1.      A cylindrical piezo-electric resonator having a piezo-electric vibrating plate incorporated into a cylindrical container having insulating property the both ends of which are sealed by metal caps, said caps being used as electrodes.

2.      A cylindrical piezo-electric resonator according to claim 1, wherein said piezo-electric vibrating plate is electrically bonded on an insulative support plate which has at its both ends conductive layers.

3.      A cylindrical piezo-electric resonator according to claim 2, wherein the both ends of said insulative support plate are electrically bonded on the inner sides at both ends of said cylindrical container.

4.      A cylindrical piezo-electric resonator according to claim 2, wherein the both ends of said insulative support plate are electrically connected through resilient conductive pieces to said metal caps.

## F I G. 1

FIG. 2A

FIG. 2B

FIG. 2C

0117253

- 3 -

FIG. 3

FIG. 4

FIG. 5

Reference numerals $5_1$ and $5_2$ represent the conductively bonded portions; 6 the piezo-electric vibrating portion; $6_1$ the piezo-electric resonator; $6_2$ the insulative support plate; $6_3$ the conductive layer; 7 the cylindrical container; $7_1$ the conductive layer; 8 the metal cap; and 9 the resilient conductive piece.

# INTERNATIONAL SEARCH REPORT

International Application No. PCT/JP83/00278

## I. CLASSIFICATION OF SUBJECT MATTER (if several classification symbols apply, indicate all) [3]

According to International Patent Classification (IPC) or to both National Classification and IPC

Int. Cl.[3] H03H 9/10 —

## II. FIELDS SEARCHED

| Minimum Documentation Searched [4] | |
|---|---|
| Classification System | Classification Symbols |
| I P C | H03H 9/00 – 9/13 |

| Documentation Searched other than Minimum Documentation to the Extent that such Documents are Included in the Fields Searched [5] | | |
|---|---|---|
| | Jitsuyo Shinan Koho | 1926 – 1982 |
| | Kokai Jitsuyo Shinan Koho | 1971 – 1982 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| A | JP,U, 56-48120     1981-4-28<br>Matsushita Electric Industrial Co., Ltd. | 1, 3, 4 |
| A | JP, Y2, 56-18012     1981-4-27<br>Matsushita Electric Industrial Co., Ltd. | 2 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| November 21, 1983   (21. 11. 83) | December 5, 1983   (05. 12. 83) |
| International Searching Authority [1] | Signature of Authorized Officer [20] |
| Japanese Patent Office | |

Form PCT/ISA/210 (second sheet) (October 1981)